# EUROPEAN PATENT SPECIFICATION

(11) **EP 3 297 409 B1**
(45) Date of publication and mention of the grant of the patent: **12.10.2022**
(21) Application number: 17189770.5
(22) Date of filing: 07.09.2017
(51) Int. Cl.: H05K 1/14, H05K 3/36

(54) **A METHOD OF CONNECTING LIGHTING MODULES AND CORRESPONDING DEVICE**
VERFAHREN ZUR VERBINDUNG VON BELEUCHTUNGSMODULEN UND ZUGEHÖRIGE VORRICHTUNG
PROCÉDÉ DE CONNEXION DE MODULES D'ÉCLAIRAGE ET DISPOSITIF CORRESPONDANT

(30) Priority: 16.09.2016 IT 201600093320
(43) Date of publication of application: 21.03.2018
(73) Proprietor: OSRAM GmbH, 80807 München (DE); OSRAM S.P.A. - SOCIETA' RIUNITE OSRAM EDISON CLERICI, 20126 Milano (IT)
(72) Inventor: BOBBO, Mr. Simon, I-30035 Mirano (Venezia) (IT); BALDO, Mr. Lorenzo, I-31040 Giavera del Montello (Treviso) (IT); VOLPATO, Mr. Luca, I-31022 Preganziol (Treviso) (IT)
(74) Representative: Bosotti, Luciano

(56) References cited:
- WO-A1-2013/125803
- DE-A1- 19 531 970
- DE-A1-102009 044 933
- GB-A- 2 531 425
- JP-U- 3 201 366
- US-A1- 2008 142 571
- US-A1- 2009 323 342
- US-A1- 2014 331 532

## Description

### Technical Field

The description refers to the connection of lighting modules.

One or more embodiments may find application in electrically-powered light radiation sources employing e.g. solid state light radiation sources, such as LED sources.

### Technological Background

Various sectors of lighting technology may employ LED lighting devices (modules) including a plurality of units adapted to be mutually connected, e.g. in parallel, in order to be supplied with a constant voltage source (e.g. 12, 24 or 48 V), or e.g. in series, in order to be supplied with a constant current source.

In order to enable an electrical connection of such units, connecting pads may be provided on each unit, e.g. on the top or bottom side of a LED stripe, which may be adapted to be cut to length according to the application and usage needs.

An electrical connection of a plurality of such modules may be achieved e.g. by soldering electric cables on such pads, or by using dedicated connectors. The use of such cables and/or connectors involves higher investment and processing costs, particularly if an automated process is implemented for the connection of such modules.

Document GB 2 531 425 A discloses a LED tube lamp comprising a tube and a bendable circuit sheet disposed inside the tube. The bendable circuit sheet has a wiring layer and a plurality of LED light sources mounted in a row along the bendable circuit sheet and connected to the wiring layer. The bendable circuit sheet is mounted to an inner surface of the tube and the bendable circuit sheet further comprises a freely extending end portion which is an integral portion of the bendable circuit sheet.

Document JP 30 201366 U discloses a light emitting diode lamp tube including a lamp tube, two caps, a circuit board, and a light emitting diode module. The two caps are fitted to both ends of the lamp tube, the circuit board is adhered to the inner peripheral surface of the lamp tube, and the light emitting diode module includes the light emitting diode unit and the lighting circuit module. The light emitting diode unit is provided on the circuit board and the lighting circuit module is provided in the two caps and is electrically connected to the conductive pins of the two caps.

Document WO2013/125803 A1 discloses an LED lighting device comprising an LED substrate having LED elements mounted thereon and a body part to which the LED substrate is connected, and which has a connection structure enabling connection to a base on which the LED lighting device is to be mounted, wherein a permanent magnet and/or a reed switch operating by the magnetism of the permanent magnet is mounted on the base, and the remainder thereof is mounted on the LED substrate or the body part.

Other documents of interest for the invention include DE 195 31 970 A1, US 2009/323342 A1, DE 10 2009 044933 A1, US 2008/142571 A1 and US 2014/331532 A1.

### Object and Summary

One or more embodiments aim at overcoming the previously outlined drawbacks, by offering the possibility of electrically connecting a plurality of LED modules arranged in parallel in a rapid, economical and reliable manner.

According to one or more embodiments, said object may be achieved thanks to a method having the features set forth in claim 1 that follows.

One or more embodiments may concern a corresponding device as claimed in claim 5.

The claims are an integral part of the technical teachings provided herein with reference to the embodiments.

One or more embodiments lead to the achievement of an overall cost reduction, especially favouring the final user, e.g. due to the following reasons:
- possibility of omitting connectors, with a consequent reduction of the necessary components (so-called Bill of Materials or BoM),
- reduction of manufacturing cost, thanks e.g. to an easier and faster wiring method,
- possibility of implementing an automated assembly process, e.g. in the case of systems employing robots for the assembly of lighting devices.

One or more embodiment increase the installation flexibility of lighting devices such as LED stripes, since they may be used e.g. for area lighting applications without originating significant extra costs due to the manufacturing process, e.g. since there is no need to develop dedicated flexible modules having different widths to meet different application and usage requirements by the customers.

One or more embodiments may be employed to easily implement electrical connection in both constant voltage and constant current supply arrangements, which entails an even higher flexibility in application and usage.

### Brief Description of the Figures

One or more embodiments will now be described, by way of non-limiting example only, with reference to the annexed Figures, wherein:
- Figure 1, including two parts respectively denoted as a) and b), shows possible general usage criteria for one or more embodiments,
- Figures 2 to 4 exemplify possible features of embodiments,
- Figures 5 to 9 exemplify possible features of embodiments,
- Figures 10 and 11 exemplify possible features of embodiments, and
- Figure 12, including two parts respectively denoted as a) and b), and Figure 13 exemplify possible features of embodiments.

It will be appreciated that, for clarity and simplicity of illustration, the various Figures may not be drawn to the same scale.

### Detailed Description

In the following description, various specific details are given in order to provide a thorough understanding of various exemplary embodiments. The embodiments may be practiced without one or several specific details, or with other methods, components, materials, etc. In other instances, well-known structures, materials or operations are not shown or described in detail to avoid obscuring various aspects of the embodiments.

Reference throughout this specification to "one embodiment" or "an embodiment" means that a particular feature, structure, or characteristic described in connection with the embodiment is included in at least one embodiment. Thus, the possible appearances of phrases such as "in one embodiment" or "in an embodiment" in various places throughout this specification are not necessarily all referring to the same embodiment.

The headings provided herein are for convenience only, and therefore do not interpret the extent of protection or scope of the embodiments.

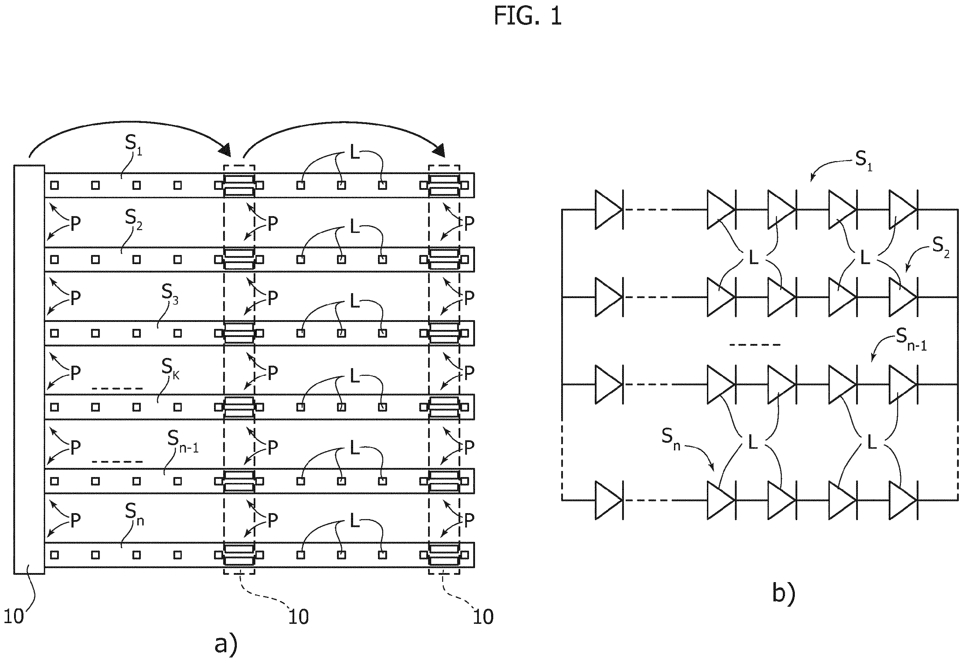

Figure 1 exemplifies possible connection solutions of a plurality of lighting modules, such as e.g. so called LED stripes or strings S₁, S₂, S₃ ,......, Sₖ, Sₙ₊₁, Sₙ (with n being virtually adapted to assume any value from least two) destined to be electrically connected with each other, e.g. in parallel, as exemplified in the circuit diagram of part b) in Figure 1.

The electrical connection may make use of pads located on such stripes, e.g. at end and/or middle locations (e.g. with a constant pitch lengthwise of the stripes).

Stripes S₁, ......, Sₙ may comprise e.g. a ribbon-like flexible substrate substantially similar to a Printed Circuit Board (PCB), along which there are distributed electrically-powered light radiation sources, e.g. solid-state sources such as LED sources L.

The reference to a parallel connection - by way of example - aims at highlighting that even though, for simplicity and clarity of illustration, the present specification will refer to a parallel electrical connection, one or more embodiments are adapted to be used for electrically connecting lighting modules also in different arrangements, e.g. parallel/series mixed arrangements, etc.

One or more embodiments may envisage devices 10 which implement an electrical connection between stripes such as previously exemplified stripes S₁, ......, Sₙ in a solution as schematically shown in part a) of Figure 1, i.e. with one or more electrically-conductive lines provided in device 10 and adapted to establish a selective electrical connection with pads P, which may optionally be positioned at different locations (end location, intermediate location etc.) of stripes S₁, ......, Sₙ, as schematically shown in dashed lines in part a) of Figure 1.

The reference to a "selective" electrical connection aims at highlighting that, in one or more embodiments, a device 10 as presently exemplified may achieve a connection between the or each electrically-conductive track of device 10 and one or more pad(s) P, selected according to the desired connection arrangement.

For example, assuming - only for simplicity of illustration - that each stripe S₁, ......, Sₙ carries a power supply pad and a ground pad, device 10 may be equipped accordingly with a supply line, for electrical connection with the supply pads of stripes S₁, ......, Sₙ, and a ground line, for electrical connection with the ground pads of stripes S₁, ......, Sₙ.

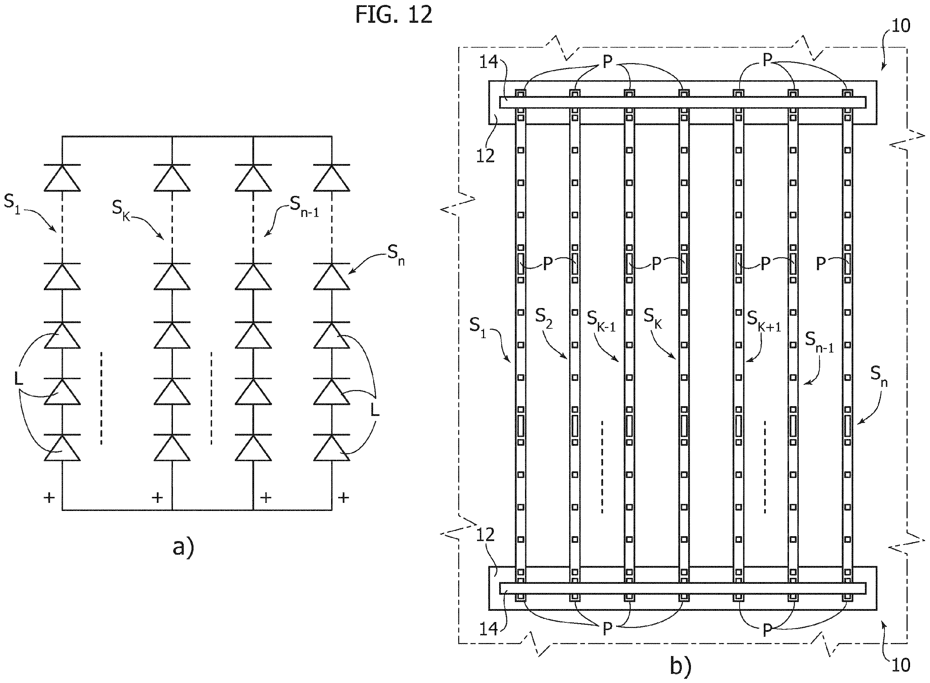

This general concept may of course be extended to arrangements including e.g. symmetrical supplies (LED+, LED-, see e.g. Figure 12) and/or a different number of pads/lines: this may be true if stripes S₁, ......, Sₙ host, in addition to supply pads P, also pads which are associated to control lines of sources L, e.g. in order to perform brightness control functions or thermal feedback functions from sources L.

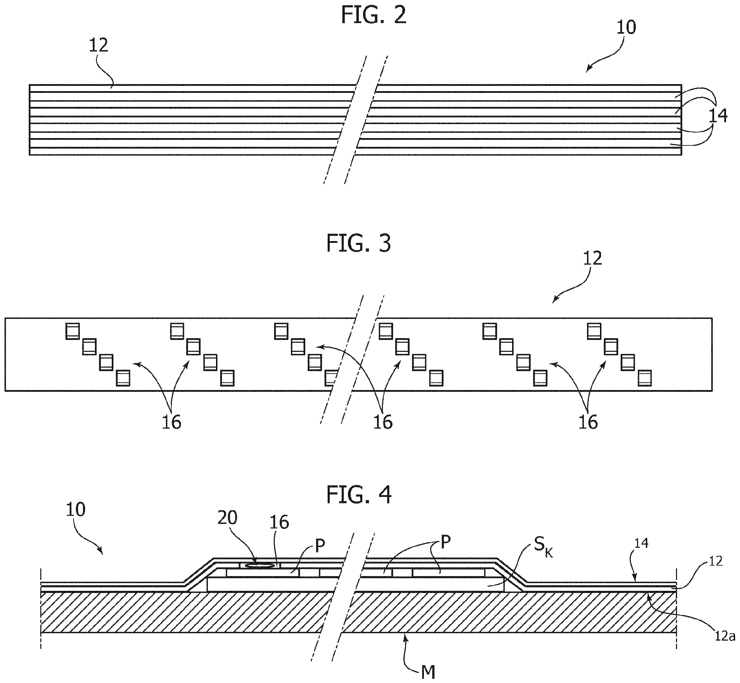

In one or more embodiments, as exemplified in Figures 2 to 4, device 10 may include an elongate, e.g. ribbon-like and flexible, substrate 12, adapted to be implemented e.g. as an adhesive tape having a surface provided with an adhesive layer 12a.

In one or more embodiments, said surface may be applied e.g. on a mounting surface M, which may host at least two LED stripes S₁, ......, Sₙ (exemplified in Figure 4 by a general stripe Sₖ).

Surface M may be any surface adapted to be used for mounting lighting devices: e.g. a surface associated to a wall or a ceiling, to an item of furniture, and so on.

Figure 4 highlights the fact that the adhesive connection of device 10 on surface M may also perform an (at least auxiliary) action in fixing LED stripes Sₖ on surface M: as a matter of fact, device 10 may be applied astride or bridge-like over stripe S, so as to keep the latter against surface M.

In one or more embodiments, the surface or substrate surface 12 opposite the surface which carries layer 12a (said further surface being optionally non-adhesive) hosts electrically-conductive lines 14 (in any number) adapted to establish an electrical contact with the pads of stripes S₁, ......, Sₙ (e.g. the general stripe Sₖ shown in Figure 4) thanks to the possible presence of openings ("windows") 16 provided in substrate 12.

Said windows 16 (which are visible e.g. in Figure 3) may be formed in substrate 12 (e.g. an adhesive tape) by way of different means, such as punching, laser cutting or equivalent methods, in positions corresponding to the locations where an electrical contact is to be established between a given electrically-conductive line 14 of device 10 and a given pad P of a stripe S₁, ......, Sₙ, as a function of the electrical contact arrangement to be implemented between line(s) 14 and pad(s) 16 of the plurality of stripes S₁, ......, Sₙ.

It will be appreciated that said implementations of the openings 16 may greatly simplify possible variations of the connection arrangements in manufacturing lighting devices.

The connection between electrically-conductive line(s) 14 and pads P may be achieved by means of solder pastes or electrically-conductive adhesive material, as schematically shown at 20 in Figure 4.

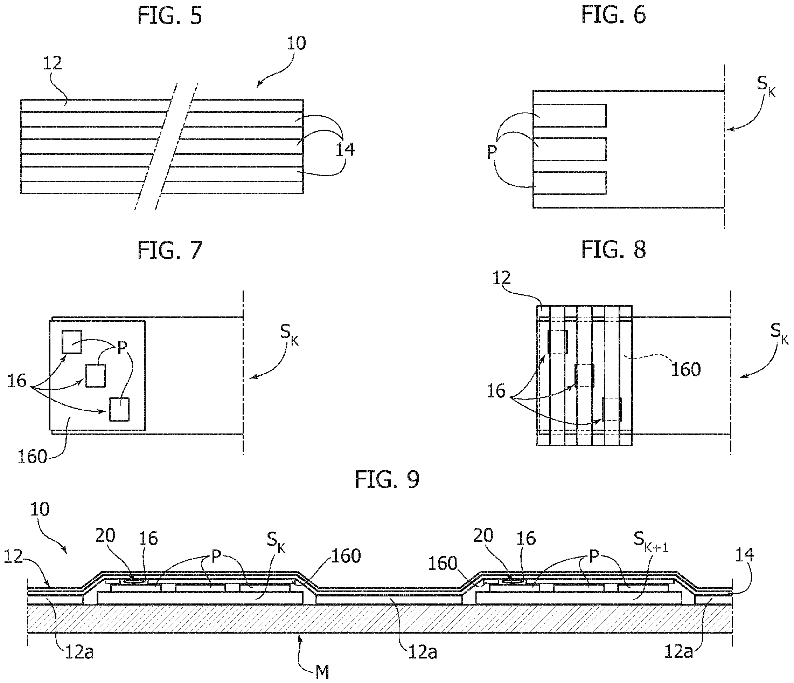

In one or more embodiments, as exemplified in Figures 5 to 9 (wherein parts or elements already described in connection with the previous Figures are denoted with the same reference number, without repeating a detailed description thereof), windows 16 may be provided in cover elements 160 (e.g. a so-called coverlay) and not in the (electrically insulating) substrate 12.

Said cover elements 160 - which are provided with windows, as shown at 16 - are adapted to be applied on the pads P of stripes S₁, ......, Sₙ (exemplified by a stripe Sₖ in the Figures 6 to 8 and by a pair of adjacent stripes Sₖ, Sₖ₊₁ in the Figures 9 to 11) so as to obtain, once again, a "selective" electrical connection with electrically-conductive lines 14 provided on the electrically insulating layer 12 of device 10.

In the various embodiments exemplified herein, the electrically-conductive lines 14 (e.g. of copper or aluminium) may be formed on substrate 12 of device 10 by means of a laminating process, or by means of a chemical etching process to be performed on a substrate 12 including e.g. polyimide (PI) (or another polymer material).

As exemplified in Figure 9, in one or more embodiments device 10 may once again be placed so to say astride or bridge-like over the stripes (Sₖ and Sₖ₊₁, in Figure 9), by taking advantage of the adhesive properties of layer 12a. Also in this case, the electrical contact or connection between pads S and electrically-conductive line(s) 14 may be established by means of electrically-conductive solder pastes or adhesive material 20, applied at openings or windows 16.

A comparison between Figure 4 and Figure 9 highlights the fact that, while in the embodiments exemplified in Figure 4 the electrically-conductive lines 14 are located, with reference to substrate 12, on the face opposite surface M, in the embodiments exemplified in Figure 9 the electrically-conductive lines 14 are located at the face of substrate 12 which will face mounting surface M.

In this case, adhesive layer 12a is adapted to include e.g. portions of double-sided adhesive tape, interposed e.g. between the stripes Sₖ, Sₖ₊₁, e.g. after the end user has applied the latter onto surface M. Moreover, both in the embodiments exemplified in Figures 2 to 4 and in the embodiments exemplified in Figures 5 to 9, a possible twofold function of device 10 is preserved, i.e. implementing a desired electrical connection arrangement between electrically-conductive stripe (s) 14 of device 10 and pads P of stripes S₁, ......, Sₙ, while at the same time facilitating the mechanical fixation of stripes S₁, ......, Sₙ (with electrical insulation) on mounting surface M. The latter may optionally be an electrically-conductive surface, e.g. a metal surface having thermal dissipation properties.

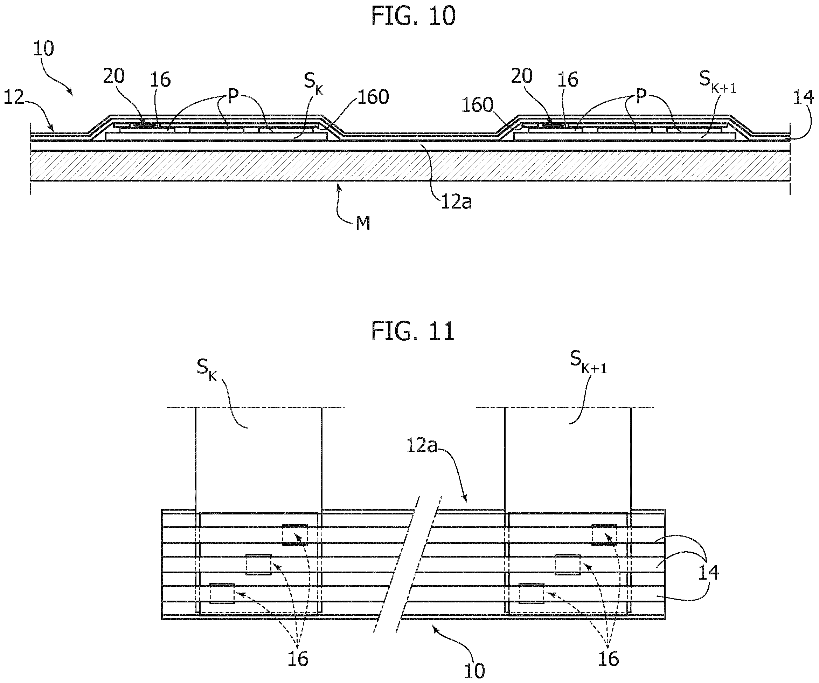

Figures 10 and 11 (wherein, once again, parts or elements already discussed with reference to the previous Figures are denoted with the same references, without repeating a detailed description thereof) exemplify the possibility of using, instead of portions of double-sided adhesive tape, one continuous ribbon-like element 12a which, as may be appreciated in Figure 10, may cooperate to fix stripes Sₖ, Sₖ₊₁ on surface M:
- either by making substrate 10 and lines 14 adhere onto surface M, at locations left uncovered by stripes Sₖ, Sₖ₊₁, in which case the lines extend astride or bridge-like over stripes Sₖ, Sₖ₊₁,
- or by being interposed between stripes Sₖ, Sₖ₊₁ and surface M, at the locations where stripes Sₖ, Sₖ₊₁ cover surface M.

Figure 12 exemplifies one or more so-to-say simplified embodiments of device 10, which may be used, e.g. in combination with LED stripes S₁, ......, Sₙ comprising a plurality of LEDs or LED units which are mutually connected in series, and which are to be supplied e.g. by means of constant current driving units.

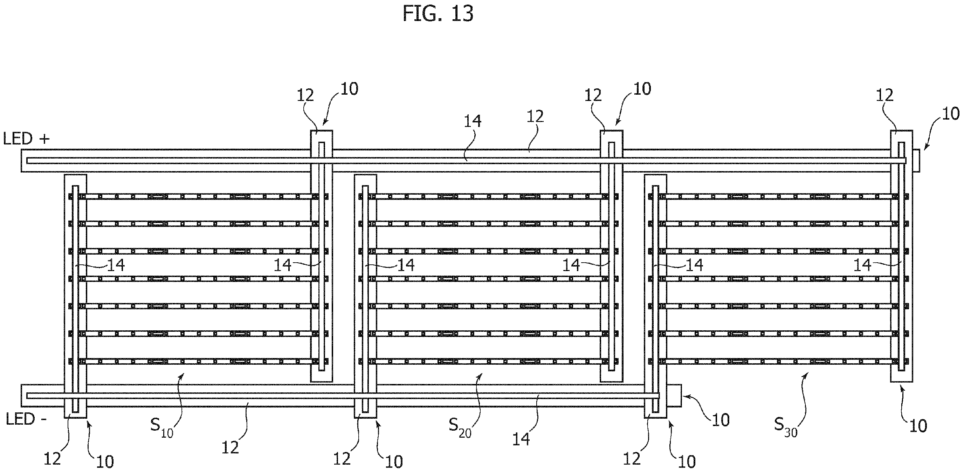

In one or more embodiments, device 10 may simply include one single electrically-conductive line or stripe 14 (e.g. of copper or aluminium) adapted to be applied onto the pads P of stripes S₁, ......, Sₙ by being fixed thereon (and on mounting surface M, not visible in Figure 13) by means of an electrically insulating substrate 12 adapted to include a (double-sided) tape which, on one hand, is adapted to adhere on mounting surface M and, on the other hand, is adapted to act adhesively both on stripes S₁, ......, Sₙ (e.g. at the ends thereof, as visible in part b) of Figure 12) and on the portions of line or stripe 14 extending between the stripes S₁, ......, Sₙ, according to criteria substantially similar to what has been described with reference to Figures 10 and 11.

Figure 13 exemplifies, by referring for simplicity to one or more embodiments as shown in Figure 12, the possibility of using devices 10 as previously exemplified in order to implement even rather articulated electrical connection arrangements.

For example, Figure 13 exemplifies the possibility of mutually connecting (e.g. in parallel) a plurality of groups of LED stripes S₁₀, S₂₀, S₃₀ (which may be present in virtually any number), each group being in turn adapted to include any number of stripes such as previously exemplified stripes S₁, ......, Sₙ.

A solution as exemplified in Figure 13 may be useful e.g. in cases wherein the length of the LED stripes is limited. In this case, the applied supply voltage may be limited e.g. by means of a constant current driving unit, as in the case of the applications denoted as SELV - Safety Extra Low Voltage.

In one or more embodiments as exemplified in the various Figures, the electrical connection between electrically-conductive line(s) 14 (no matter how they are implemented) and pads P (widely irrespective of the specific technological solutions adopted for the implementation thereof) may be achieved by means of different techniques, such as for example:
- tin soldering, e.g. hot tip soldering, or other methods of local heating of the contact area (keeping in mind that the pads P of LED stripes as exemplified herein may have a tin finish),
- connection by means of electrically-conductive solder pastes or electrically-conductive adhesives,
- ultrasound soldering (which does not require dispensing a solder paste filling as denoted with 20 in various Figures),
- brazing.

The previous list is of course merely exemplary, and does not limit the embodiments.

The extent of protection is defined by the annexed claims.

## Claims

1. A method of providing electrical connection to electrically-powered LED stripes (S₁, ......, Sₙ) having at least one electrical contact pad (P) at one face of the stripe, the method including:
- arranging on said mounting surface (M) at least two said LED stripes (Sₖ, Sₖ₊₁), each with at least one respective electrical contact pad (P) facing away from the mounting surface (M), and
- adhesively applying at least one electrically-conductive line (14) onto said mounting surface (M) having said at least two LED stripes (Sₖ, Sₖ₊₁) arranged thereon, with said at least one electrically-conductive line (14) extending between respective electrical contact pads (P) of said at least two LED stripes (Sₖ, Sₖ₊₁) by providing electrical connection (20) between said respective electrical contact pads (P) and said at least one electrically-conductive line (14),
wherein the method includes:
- arranging said at least one electrically-conductive line (14) on a ribbon-like, electrically non-conductive substrate (12),
- adhesively (12a) applying said electrically non-conductive substrate (12) onto said mounting surface (M) having said at least two LED stripes (Sₖ) arranged thereon, and
- i) setting said electrically non-conductive substrate (12) between said at least one electrically-conductive line (14) and each of said at least two LED stripes (Sₖ) and providing in said electrically non-conductive substrate (12) at least one opening (16) providing a passageway for electrical connection (20) between said at least one electrically-conductive line (14) and at least one respective electrical contact pad (P) in each of said at least two LED stripes (Sₖ), or
- ii) setting said at least one electrically-conductive line (14) between said electrically non-conductive substrate (12) and each of said at least two LED stripes (Sₖ) and providing between said at least one electrically-conductive line (14) and each of said at least two LED stripes (Sₖ) an electrically non-conductive cover (160) having at least one opening (16) therein providing a passageway for electrical connection (20) between said at least one electrically-conductive line (14) and said at least one respective electrical contact pad (P) in each of said at least two LED stripes.

2. The method of claim 1, wherein said providing electrical connection includes:
- providing electrically-conductive material (20) between said at least one respective electrical contact pad (P) and said at least one electrically-conductive line (14); or
- ultrasound welding said at least one respective electrical contact pad (P) and said at least one electrically-conductive line (14).

3. The method of any of the previous claims, including adhesively (12a) applying said at least one electrically-conductive line (14) onto said mounting surface (M) by means of an adhesive layer (12a) extending at locations of said mounting surface (M) left uncovered by said at least two LED stripes (Sₖ, Sₖ₊₁) arranged thereon.

4. The method of any of the previous claims, including adhesively (12a) applying said at least one electrically-conductive line (14) onto said mounting surface (M) by means of an adhesive layer (12a) extending between said mounting surface (M) and each of said at least two LED stripes (Sₖ, Sₖ₊₁) arranged thereon.

5. A lighting device including at least two LED stripes (Sₖ, Sₖ₊₁) arranged on a mounting surface (M) each with at least one respective electrical contact pad (P) facing away from the mounting surface (M), and
- at least one electrically-conductive line (14) adhesively applied onto said mounting surface (M) having said at least two LED stripes (Sₖ, Sₖ₊₁) arranged thereon, with said at least one electrically-conductive line (14) extending between respective electrical contact pads (P) of said at least two LED stripes (Sₖ, Sₖ₊₁₎, by providing electrical connection (20) between said respective electrical contact pads (P) and said at least one electrically-conductive line (14),
wherein the lighting device includes:
- said at least one electrically-conductive line (14) arranged on a ribbon-like, electrically non-conductive substrate (12),
- said electrically non-conductive substrate (12) adhesively (12a) applied onto said mounting surface (M) having at least two LED stripes (Sₖ) arranged thereon,
and wherein the lighting device includes:
- i) said electrically non-conductive substrate (12) set between said at least one electrically-conductive line (14) and each of said at least two LED stripes (Sₖ) with at least one opening (16) in said electrically non-conductive substrate (12) providing a passageway for electrical connection (20) between said at least one electrically-conductive line (14) and at least one respective electrical contact pad (P) in each of said at least two LED stripes (Sₖ), or
- ii) said at least one electrically-conductive line (14) set between said electrically non-conductive substrate (12) and each of said at least two LED stripes (Sₖ) and an electrically non-conductive cover (160) provided between said at least one electrically-conductive line (14) and each of said at least two LED stripes (Sₖ) and having at least one opening (16) therein providing a passageway for electrical connection (20) between said at least one electrically-conductive line (14) and at least one respective electrical contact pad (P) in each of said at least two LED stripes.

6. The lighting device of claim 5, wherein said electrical connection includes:
- electrically-conductive material (20) between said at least one respective electrical contact pad (P) and said at least one electrically-conductive line (14); or
- said at least one respective electrical contact pad (P) and said at least one electrically-conductive line (14) ultrasound welded together.

7. The lighting device of any of claims 5 to 6, including said at least one electrically-conductive line (14) adhesively (12a) applied onto said mounting surface (M) by means of an adhesive layer (12a) extending at locations of said mounting surface (M) left uncovered by said at least two LED stripes (Sₖ, Sₖ₊₁) arranged thereon.

8. The lighting device of any of claims 5 to 7, including said at least one electrically-conductive line (14) adhesively (12a) applied onto said mounting surface (M) by means of an adhesive layer (12a) extending between said mounting surface (M) and each of said at least two LED stripes (Sₖ, Sₖ₊₁) arranged thereon.

## Patentansprüche

1. Verfahren zum Bereitstellen einer elektrischen Verbindung zu elektrisch betriebenen LED-Streifen (S₁ ,..., Sₙ), die mindestens ein elektrisches Kontaktpad (P) an einer Seite des Streifens aufweisen, das Verfahren beinhaltend:
- Anordnen, auf der Montagefläche (M), von mindestens zwei LED-Streifen (Sₖ, Sₖ₊₁), jeder mit mindestens einem jeweiligen elektrischen Kontaktpad (P), das von der Montagefläche (M) abgewandt ist, und
- klebendes Aufbringen von mindestens einer elektrisch leitfähigen Leitung (14) auf die Montagefläche (M), die die mindestens zwei darauf angeordneten LED-Streifen (Sₖ, Sₖ₊₁) aufweist, wobei sich die mindestens eine elektrisch leitfähige Leitung (14) zwischen jeweiligen elektrischen Kontaktpads (P) der mindestens zwei LED-Streifen (Sₖ, Sₖ₊₁) erstreckt, indem eine elektrische Verbindung (20) zwischen den jeweiligen elektrischen Kontaktpads (P) und der mindestens einen elektrisch leitfähigen Leitung (14) bereitgestellt wird,
wobei das Verfahren beinhaltet:
- Anordnen der mindestens einen elektrisch leitfähigen Leitung (14) auf einem bandartigen, elektrisch nicht leitfähigen Substrat (12),
- klebendes (12a) Aufbringen des elektrisch nicht leitfähigen Substrats (12) auf die Montagefläche (M), die die mindestens zwei darauf angeordneten LED-Streifen (Sₖ) aufweist, und
- i) Einsetzen des elektrisch nicht leitfähigen Substrats (12) zwischen der mindestens einen elektrisch leitfähigen Leitung (14) und jedem der mindestens zwei LED-Streifen (Sₖ) und Bereitstellen mindestens einer Öffnung (16) im elektrisch nicht leitfähigen Substrat (12), die einen Durchgang für eine elektrische Verbindung (20) zwischen der mindestens einen elektrisch leitfähigen Leitung (14) und mindestens einem jeweiligen elektrischen Kontaktpad (P) in jedem der mindestens zwei LED-Streifen (Sₖ) bereitstellt, oder
- ii) Einsetzen der mindestens einen elektrisch leitfähigen Leitung (14) zwischen dem elektrisch nicht leitfähigen Substrat (12) und jedem der mindestens zwei LED-Streifen (Sₖ) und Bereitstellen einer elektrisch nicht leitfähigen Abdeckung (160) zwischen der mindestens einen elektrisch leitfähigen Leitung (14) und jedem der mindestens zwei LED-Streifen (Sₖ), die mindestens eine Öffnung (16) darin aufweist, die einen Durchgang für eine elektrische Verbindung (20) zwischen der mindestens einen elektrisch leitfähigen Leitung (14) und dem mindestens einen jeweiligen elektrischen Kontaktpad (P) in jedem der mindestens zwei LED-Streifen bereitstellt.

2. Verfahren nach Anspruch 1, wobei das Bereitstellen einer elektrischen Verbindung beinhaltet:
- Bereitstellen von elektrisch leitfähigem Material (20) zwischen dem mindestens einen jeweiligen elektrischen Kontaktpad (P) und der mindestens einen elektrisch leitfähigen Leitung (14); oder
- Ultraschallschweißen des mindestens einen jeweiligen elektrischen Kontaktpads (P) und der mindestens einen elektrisch leitfähigen Leitung (14).

3. Verfahren nach einem der vorhergehenden Ansprüche, beinhaltend klebendes (12a) Aufbringen der mindestens einen elektrisch leitfähigen Leitung (14) auf die Montagefläche (M) mittels einer Klebstoffschicht (12a), die sich an Stellen der Montagefläche (M) erstreckt, die von den mindestens zwei darauf angeordneten LED-Streifen (Sₖ, Sₖ₊₁) unbedeckt gelassen werden.

4. Verfahren nach einem der vorhergehenden Ansprüche, beinhaltend klebendes (12a) Aufbringen der mindestens einen elektrisch leitfähigen Leitung (14) auf die Montagefläche (M) mittels einer Klebstoffschicht (12a), die sich zwischen der Montagefläche (M) und jedem der mindestens zwei darauf angeordneten LED-Streifen (Sₖ, Sₖ₊₁) erstreckt.

5. Beleuchtungsvorrichtung, beinhaltend mindestens zwei LED-Streifen (Sₖ, Sₖ₊₁), die auf einer Montagefläche (M) angeordnet sind, jeder mit mindestens einem jeweiligen elektrischen Kontaktpad (P), das von der Montagefläche (M) abgewandt ist, und
- mindestens eine elektrisch leitfähige Leitung (14), die klebend auf die Montagefläche (M) aufgebracht ist, die die mindestens zwei darauf angeordneten LED-Streifen (Sₖ, Sₖ₊₁) aufweist, wobei sich die mindestens eine elektrisch leitfähige Leitung (14) zwischen jeweiligen elektrischen Kontaktpads (P) der mindestens zwei LED-Streifen (Sₖ, Sₖ₊₁) erstreckt, indem eine elektrische Verbindung (20) zwischen den jeweiligen elektrischen Kontaktpads (P) und der mindestens einen elektrisch leitfähigen Leitung (14) bereitgestellt wird,
wobei die Beleuchtungsvorrichtung beinhaltet:
- die mindestens eine elektrisch leitfähige Leitung (14), die auf einem bandartigen, elektrisch nicht leitfähigen Substrat (12) angeordnet ist,
- das elektrisch nicht leitfähige Substrat (12), das klebend (12a) auf die Montagefläche (M) aufgebracht ist, die mindestens zwei darauf angeordnete LED-Streifen (Sₖ) aufweist, und wobei die Beleuchtungsvorrichtung beinhaltet:
- i) das elektrisch nicht leitfähige Substrat (12), das zwischen der mindestens einen elektrisch leitfähigen Leitung (14) und jedem der mindestens zwei LED-Streifen (Sₖ) eingesetzt ist, mit mindestens einer Öffnung (16) im elektrisch nicht leitfähigen Substrat (12), die einen Durchgang für eine elektrische Verbindung (20) zwischen der mindestens einen elektrisch leitfähigen Leitung (14) und mindestens einem jeweiligen elektrischen Kontaktpad (P) in jedem der mindestens zwei LED-Streifen (Sₖ) bereitstellt, oder
- ii) die mindestens eine elektrisch leitfähige Leitung (14), die zwischen dem elektrisch nicht leitfähigen Substrat (12) und jedem der mindestens zwei LED-Streifen (Sₖ) eingesetzt ist, und eine elektrisch nicht leitfähige Abdeckung (160), die zwischen der mindestens einen elektrisch leitfähigen Leitung (14) und jedem der mindestens zwei LED-Streifen (Sₖ) bereitgestellt ist und mindestens eine Öffnung (16) darin aufweist, die einen Durchgang für eine elektrische Verbindung (20) zwischen der mindestens einen elektrisch leitfähigen Leitung (14) und mindestens einem jeweiligen elektrischen Kontaktpad (P) in jedem der mindestens zwei LED-Streifen bereitstellt.

6. Beleuchtungsvorrichtung nach Anspruch 5, wobei die elektrische Verbindung beinhaltet:
- elektrisch leitfähiges Material (20) zwischen dem mindestens einen jeweiligen elektrischen Kontaktpad (P) und der mindestens einen elektrisch leitfähigen Leitung (14); oder
- das mindestens eine jeweilige elektrische Kontaktpad (P) und die mindestens eine elektrisch leitfähige Leitung (14) miteinander ultraschallverschweißt sind.

7. Beleuchtungsvorrichtung nach einem der Ansprüche 5 bis 6, beinhaltend die mindestens eine elektrisch leitfähige Leitung (14), die klebend (12a) auf die Montagefläche (M) mittels einer Klebstoffschicht (12a) aufgebracht ist, die sich an Stellen der Montagefläche (M) erstreckt, die von den mindestens zwei darauf angeordneten LED-Streifen (Sₖ, Sₖ₊₁) unbedeckt gelassen werden.

8. Beleuchtungsvorrichtung nach einem der Ansprüche 5 bis 7, beinhaltend die mindestens eine elektrisch leitfähige Leitung (14), die klebend (12a) auf die Montagefläche (M) mittels einer Klebstoffschicht (12a) aufgebracht ist, die sich zwischen der Montagefläche (M) und jedem der mindestens zwei darauf angeordneten LED-Streifen (Sₖ, Sₖ₊₁) erstreckt.

## Revendications

1. Un procédé pour établir une connexion électrique à des bandes de LED électriquement alimentées (Si, ..., Sₙ), possédant au moins une plage de contact électrique (P) sur une face de la bande, le procédé comprenant :
- l'agencement sur ladite surface de montage (M) d'au moins deux bandes de LED (Sₖ, Sₖ₊₁), chacune avec au moins une plage de contact électrique respective (P) tournée en éloignement de la surface de montage (M), et
- l'application adhérente d'au moins une ligne électriquement conductrice (14) sur ladite surface de montage (M) avec lesdites au moins deux bandes de LED (Sₖ, Sₖ₊₁) agencées dessus, avec ladite au moins une ligne électriquement conductrice (14) qui s'étend entre des plages de contact électrique respectives (P) desdites aux moins deux bandes de LED (Sₖ, Sₖ₊₁) en assurant une connexion électrique (20) entre lesdites plages de contact électrique respectives (P) et ladite au moins une ligne électriquement conductrice (14),
dans lequel le procédé comprend :
- l'agencement de ladite au moins une ligne électriquement conductrice (14) sur un substrat électriquement non conducteur en forme de ruban (12),
- l'application adhérente (12a) dudit substrat électriquement non conducteur (12) sur ladite surface de montage (M) avec lesdites deux bandes de LED (Sₖ) agencées dessus, et
- i) la mise en place dudit substrat électriquement non conducteur (12) entre ladite au moins une ligne électriquement conductrice (14) et chacune des au moins deux bandes de LED (Sₖ), et la formation dans ledit substrat électriquement non conducteur (12) d'au moins une ouverture (16) formant un passage pour une connexion électrique (20) entre ladite au moins une ligne électriquement conductrice (14) et au moins une plage de contact électrique respective (P) de chacune desdites au moins deux bandes de LED (Sₖ), ou
- ii) la mise en place de ladite au moins une ligne électriquement conductrice (14) entre ledit substrat électriquement non conducteur (12) et chacune desdites au moins deux bandes de LED (Sₖ), et la formation entre ladite au moins une ligne électriquement conductrice (14) et chacune des au moins deux bandes de LED (Sₖ) d'un recouvrement électriquement non conducteur (160) avec dedans au moins une ouverture (16) formant un passage pour une connexion électrique (20) entre ladite au moins une ligne électriquement conductrice (14) et ladite au moins une plage de contact électrique respective (P) de chacune desdites au moins deux bandes de LED.

2. Le procédé de la revendication 1, dans lequel ladite formation de la connexion électrique comprend :
- la mise en place d'un matériau électriquement conducteur (20) entre ladite au moins une plage de contact électrique respective (P) et ladite au moins une ligne électriquement conductrice (14) ; ou
- le soudage aux ultrasons de ladite au moins une plage de contact électrique respective (P) et de ladite au moins une ligne électriquement conductrice (14).

3. Le procédé de l'une des revendications précédentes, comprenant l'application adhérente (12a) de ladite au moins une ligne électriquement conductrice (14) sur ladite surface de montage (M) au moyen d'une couche adhésive (12a) s'étendant en des emplacements de ladite surface de montage (M) laissés découverts par lesdites au moins deux bandes de LED (Sₖ, Sₖ₊₁) agencées dessus.

4. Le procédé de l'une des revendications précédentes, comprenant l'application adhérente (12a) de ladite au moins une ligne électriquement conductrice (14) sur ladite surface de montage (M) au moyen d'une couche adhésive (12a) s'étendant entre ladite surface de montage (M) et chacune desdites au moins deux bandes de LED (Sₖ, Sₖ₊₁) agencées dessus.

5. Un dispositif d'éclairage comprenant au moins deux bandes de LED (Sₖ, Sₖ₊₁) agencées sur une surface de montage (M), chacune avec au moins une plage de contact électrique respective (P) tournée en éloignement de la surface de montage (M), et
- au moins une ligne électriquement conductrice (14) appliquée de façon adhérente sur ladite surface de montage (M) avec lesdites au moins deux bandes avec lesdites au moins deux bandes de LED (Sₖ, Sₖ₊₁) agencées dessus, avec ladite au moins une ligne électriquement conductrice (14) qui s'étend entre des plages de contact électrique respectives (P) desdites aux moins deux bandes de LED (Sₖ, Sₖ₊₁) en assurant une connexion électrique (20) entre lesdites plages de contact électrique respectives (P) et ladite au moins une ligne électriquement conductrice (14),
dans lequel le dispositif d'éclairage comprend :
- ladite au moins une ligne électriquement conductrice (14) agencée sur un substrat électriquement non conducteur en forme de ruban (12),
- ledit substrat électriquement non conducteur (12) appliqué de façon adhérente (12a) sur ladite surface de montage (M) avec lesdites deux bandes de LED (Sₖ) agencées dessus,
et dans lequel le dispositif d'éclairage comprend :
- i) ledit substrat électriquement non conducteur (12) disposé entre ladite au moins une ligne électriquement conductrice (14) et chacune des au moins deux bandes de LED (Sₖ), avec dans ledit substrat électriquement non conducteur (12) au moins une ouverture (16) formant un passage pour une connexion électrique (20) entre ladite au moins une ligne électriquement conductrice (14) et au moins une plage de contact électrique respective (P) de chacune desdites au moins deux bandes de LED (Sₖ), ou
- ii) ladite au moins une ligne électriquement conductrice (14) disposée entre ledit substrat électriquement non conducteur (12) et chacune desdites au moins deux bandes de LED (Sₖ), et un recouvrement électriquement non conducteur (160) formé entre ladite au moins une ligne électriquement conductrice (14) et chacune des au moins deux bandes de LED (Sₖ) et avec au moins une ouverture (16) dedans qui forme un passage pour une connexion électrique (20) entre ladite au moins une ligne électriquement conductrice (14) et ladite au moins une plage de contact électrique respective (P) de chacune desdites au moins deux bandes de LED.

6. Le dispositif d'éclairage de la revendication 5, dans lequel ladite connexion électrique comprend :
- un matériau électriquement conducteur (20) entre ladite au moins une plage de contact électrique respective (P) et ladite au moins une ligne électriquement conductrice (14) ; ou
- au moins une plage de contact électrique respective (P) et ladite au moins une ligne électriquement conductrice (14) soudées ensemble aux ultrasons.

7. Le dispositif d'éclairage de l'une des revendications 5 à 6, comprenant ladite au moins une ligne électriquement conductrice (14) appliquée de façon adhérente (12a) sur ladite surface de montage (M) au moyen d'une couche adhésive (12a) s'étendant en des emplacements de ladite surface de montage (M) laissés découverts par lesdites au moins deux bandes de LED (Sₖ, Sₖ₊₁) agencées dessus.

8. Le dispositif d'éclairage de l'une des revendications 5 à 7, comprenant ladite au moins une ligne électriquement conductrice (14) appliquée de façon adhérente (12a) sur ladite surface de montage (M) au moyen d'une couche adhésive (12a) s'étendant entre ladite surface de montage (M) et chacune desdites au moins deux bandes de LED (Sₖ, Sₖ₊₁) agencées dessus.
